# EUROPEAN PATENT SPECIFICATION

(11) **EP 1 148 550 B1**
(45) Date of publication and mention of the grant of the patent: **04.02.2004**
(21) Application number: 01302706.5
(22) Date of filing: 23.03.2001
(51) Int. Cl.: H01L 23/66, H05K 9/00, H01P 1/201

(54) **Radio frequency amplifier with small distortion and superior isolation**
Hochfrequenzverstärker mit geringen Verzerrungen und hoher Abschirmung
Amplificateur hautes frequences à faible distortion et isolation élevée

(30) Priority: 20.04.2000 JP 2000126240
(43) Date of publication of application: 24.10.2001
(73) Proprietor: ALPS ELECTRIC CO., LTD., Ota-ku Tokyo 145 (JP)
(72) Inventor: Suzuki, Shigetaki, Alps Electric Co., Ltd., Ota-ku, Tokyo 145 (JP); Takayama, Akira, Alps Electric Co., Ltd., Ota-ku, Tokyo 145 (JP)
(74) Representative: Kensett, John Hinton

(56) References cited:
- US-A- 5 412 340
- US-A- 5 581 217
- US-A- 6 005 455
- PATENT ABSTRACTS OF JAPAN vol. 014, no. 117 (E-0898), 5 March 1990 (1990-03-05) & JP 01 314408 A (FUJITSU LTD;OTHERS: 01), 19 December 1989 (1989-12-19)

## Description

### 1. Field of the Invention

The present invention relates to radio frequency amplifiers for use in satellite communication transmitters and the like.

### 2. Description of the Related Art

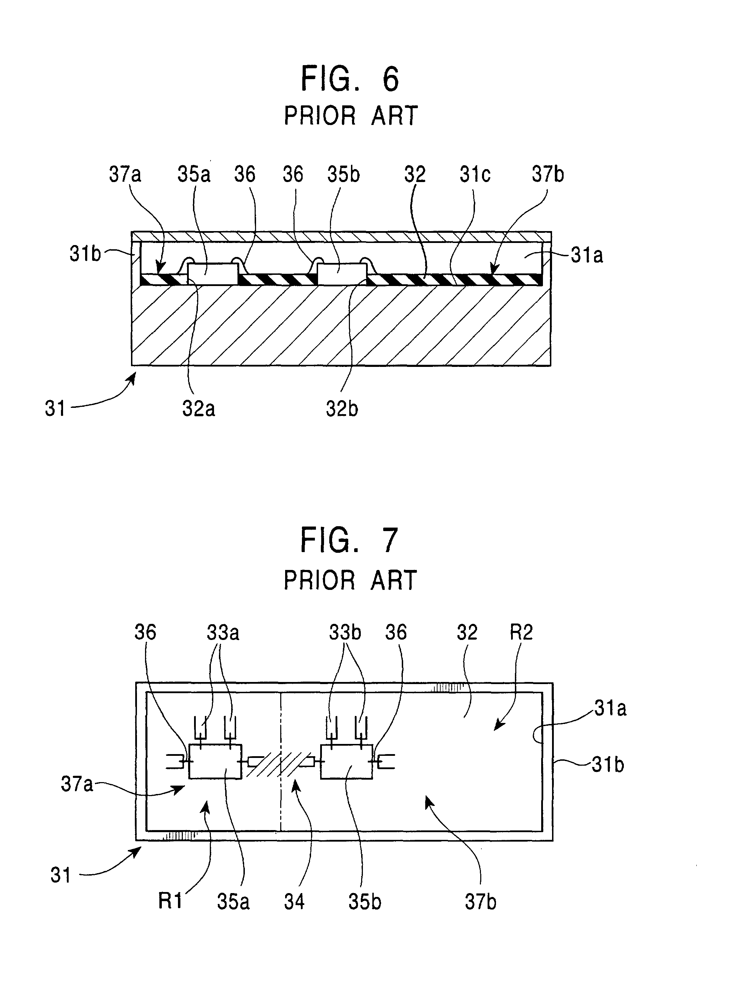

A conventional radio frequency amplifier for use in a millimeter-wave band (frequency ranges from 20 to 40 GHz) is described with reference to Figs. 6 and 7. A casing 31 is formed of metal, such as brass or the like, and serves as a heat sink. The casing 31 includes a concave storage part 31a with an opening at the upper part and a side wall 31b provided so as to surround the storage part 31a.

A circuit board 32, which is formed of a printed circuit board, includes a pair of holes 32a and 32b which are formed with a predetermined distance therebetween. Wiring patterns 33a and 33b, which are formed of conductive patterns, are provided on the top surface of the circuit board 32. A filter 34, which is formed of oblique conductive patterns with a predetermined distance among the patterns, is provided between the wiring patterns 33a and 33b which are provided between the holes 32a and 32b.

The filter 34 separates the top surface of the circuit board 32 into first and second regions R1 and R2.

A ground pattern (not shown) is formed on the whole back surface of the circuit board 32.

The above-described circuit board 32 is mounted in the storage part 31a by appropriate means while the ground pattern is disposed on a bottom portion 31c of the storage part 31a.

Amplifying elements (field effect transistors (FETs)) 35a and 35b, which are bare chips, are inserted into the holes 32a and 32b of the circuit board 32. The amplifying elements 35a and 35b are fixed at the bottom thereof to the bottom portion 31c of the casing 31 using electrically conductive adhesive.

Wires 36 are bonded to the amplifying elements 35a and 35b, and hence the amplifying elements 35a and 35b are connected to the wiring patterns 33a and 33b, which are formed in the first and second regions R1 and R2, respectively.

Various electrical components (not shown) are connected to the wiring patterns 33a and 33b formed in the first and second regions R1 and R2, respectively, using solder. With these electrical components and the bare-chip amplifying elements 35a and 35b, a first amplifier circuit 37a including a bias circuit or the like is formed in the first region R1, and a second amplifier circuit 37b including a bias circuit or the like is formed in the second region R2.

A covering 38 formed of metal is mounted by appropriate means so as to cover the opening of the casing 31, thus electrically shielding the storage part 31a.

With the foregoing arrangement, a radio frequency amplifier is formed.

In the conventional radio frequency amplifier, the filter 34 is formed of oblique conductive patterns. On this account, a large transmission loss is caused, and distortion of the amplifier circuits 37a and 37b becomes worse. Thus, the performance of the conventional radio frequency amplifier becomes less efficient.

Since direct coupling is established between the first and second amplifier circuits 37a and 37b, isolation is unsatisfactory.

### SUMMARY OF THE INVENTION

Accordingly, it is an object of the present invention to provided a high-performance radio frequency amplifier in which distortion of amplifier circuits is small and isolation is superior.

According to an aspect of the present invention there is provided a radio frequency amplifier comprising:
a casing formed of metal, said casing including a storage part; a circuit board provided in said storage part, on which first and second amplifier circuits are formed; and a filter provided between the first and second amplifier circuits; wherein said filter includes a waveguide filter being disposed in said storage part and comprising a main body formed of metal that encloses a cavity, wherein the cavity of the main body is provided with an opening on the underside thereof and is opposed to a bottom portion of said casing; wherein the bottom portion is provided with a cavity arranged to oppose the cavity of the main body; and wherein said main body separates said storage part into first and second chambers, the first amplifier circuit being formed in the first chamber, and the second amplifier circuit being formed in the second chamber; the waveguide filter being mounted between the first and second amplifier circuits to provide electrical shielding between the first and second amplifier circuits.

The first and second amplifier circuits may include first and second amplifying elements, respectively, and the amplifying elements may be bare chips. The first and second amplifying elements may be connected to a wiring pattern on the circuit board, with the waveguide filter provided between the amplifying elements.

The concave cavity of the main body may be provided with an opening on the underside of the cavity. The opening may be opposed to a bottom portion of the casing, whereby the bottom portion and the main body form the waveguide filter.

The bottom portion of the casing may be provided with a concave cavity. The cavity of the casing and the cavity of the main body may be arranged so as to be opposed to each other, with the circuit board provided between the bottom portion and the main body. A probe formed by part of the wiring pattern on the circuit board may be located in the storage part.

The radio frequency amplifier may further include a covering for covering the opening of the storage part. The inside of the covering may be brought into contact with a top surface of the waveguide filter.

According to the present invention, the transmission loss and distortion of amplifier circuits are small as compared with conventional circuits. It is possible to provide a high-performance radio frequency amplifier. Unlike the conventional circuits, direct coupling is not established between first and second amplifier circuits, and hence isolation is improved. Moreover, the structure of the radio frequency amplifier is simplified, and the radio frequency amplifier can be provided at low cost. Furthermore, electrical shielding between the first and second amplifier circuits is reliably provided by a main body, and isolation is further improved. Since a casing forms part of a waveguide filter, the structure of the waveguide filter is simplified. The waveguide filter is reduced in height, and it is possible to provide a small waveguide at low cost. A circuit board can be easily mounted; and probes are formed by wiring patterns. It is therefore possible to provide a radio frequency amplifier that can be assembled easily at low cost. An embodiment of the present invention, will now be described, by way of example only, with reference to the accompanying diagrammatic drawings, in which:
Fig. 1 is a sectional view of basic portions of a radio frequency amplifier according to an embodiment of the present invention;
Fig. 2 is a plan view of the radio frequency amplifier in which a covering is removed;
Fig. 3 is a plan view of the radio frequency amplifier in which the covering and a main body are removed;
Fig. 4 is a sectional view taken along the line IV-IV of Fig. 1;
Fig. 5 is an exploded perspective view of the radio frequency amplifier;
Fig. 6 is a sectional view of basic portions of a conventional radio frequency amplifier; and
Fig. 7 is a plan view of the conventional radio frequency amplifier in which a covering is removed.

### DESCRIPTION OF THE PREFERRED EMBODIMENTS

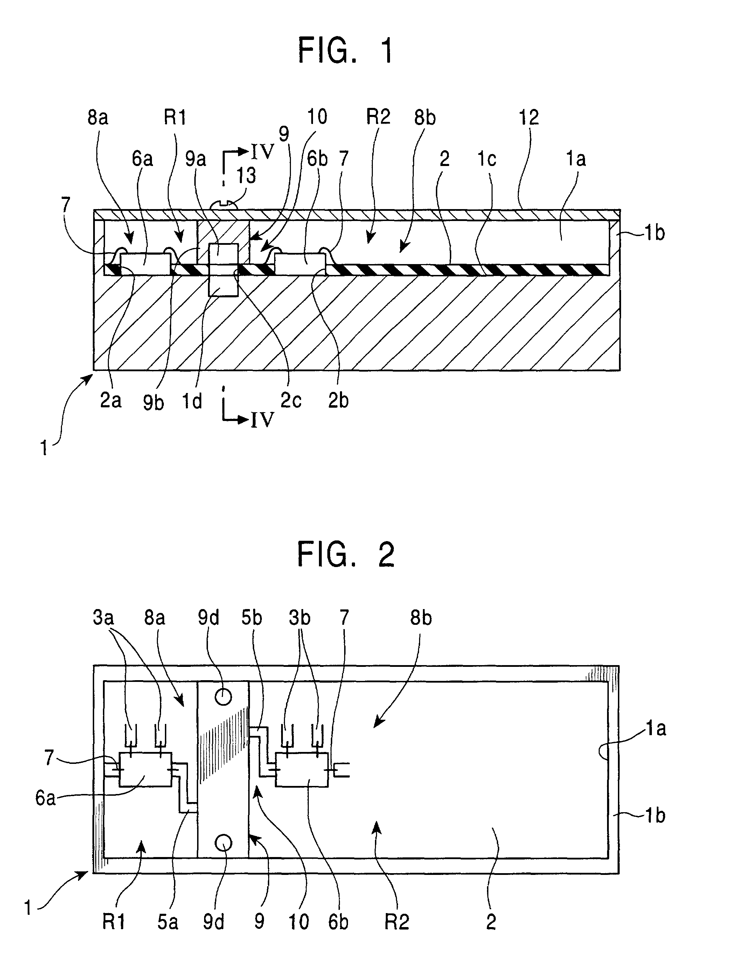

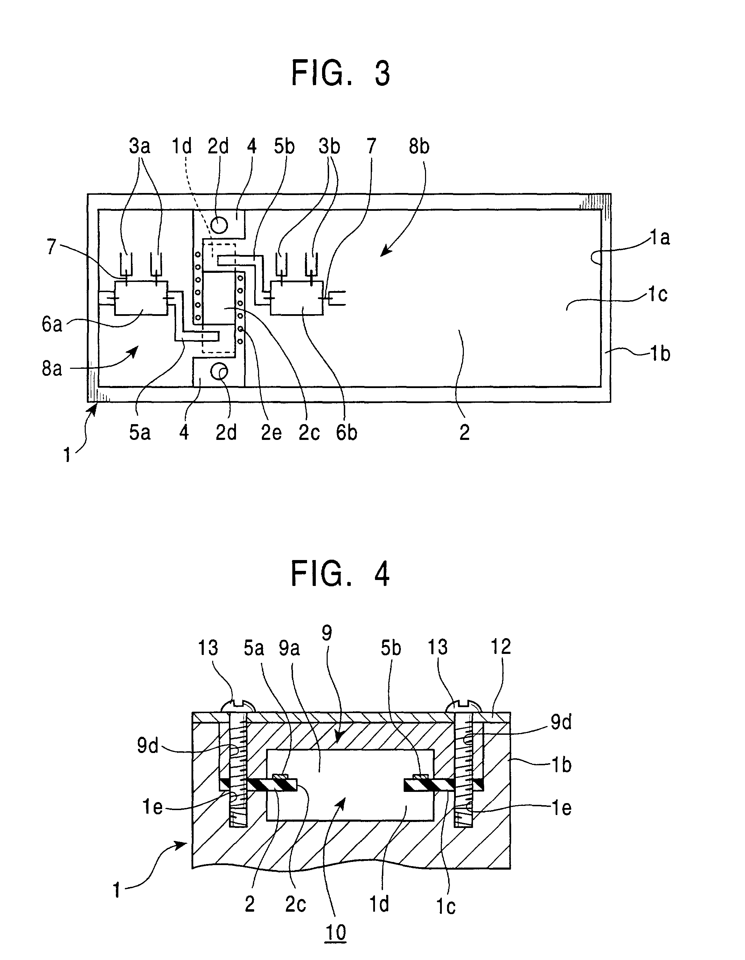

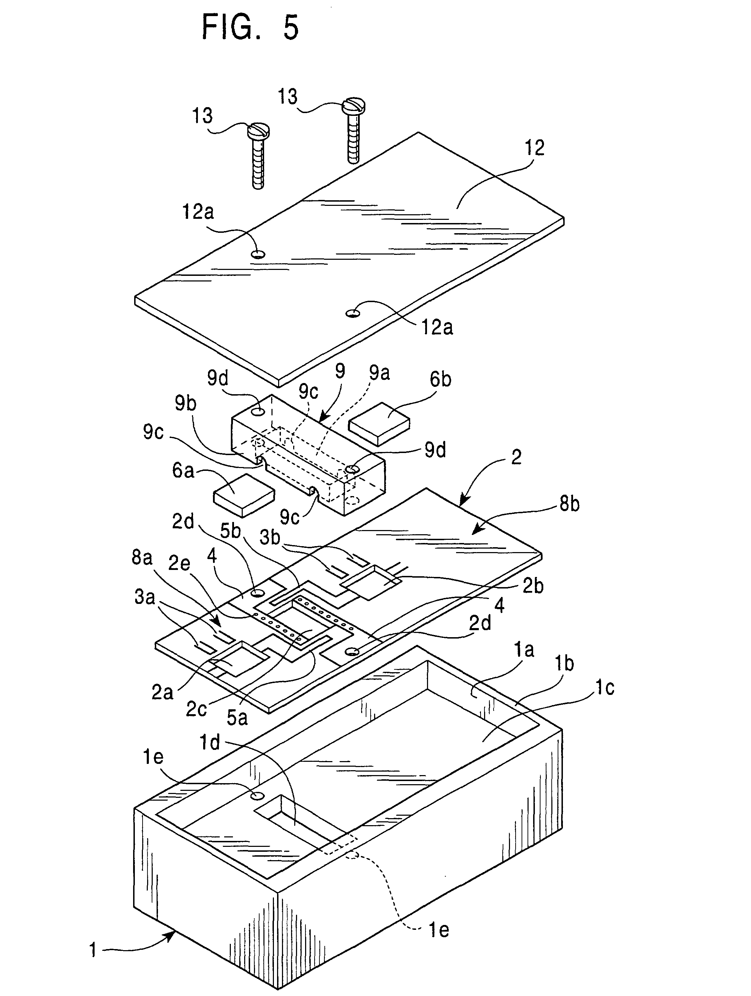

The accompanying drawings are described as follows. Fig. 1 shows basic portions of a radio frequency amplifier according to an embodiment of the present invention; Fig. 2 shows the radio frequency amplifier in which a covering is removed; Fig. 3 shows the radio frequency amplifier in which the covering and a main body are removed; Fig. 4 shows a sectional view taken along the line IV-IV of Fig. 1; and Fig. 5 shows the exploded radio frequency amplifier.

Referring to Figs. 1 to 5, the structure of the radio frequency amplifier of the present embodiment for use in a millimeter-wave band (frequency ranges from 20 to 40 GHz) is described. A casing 1 is formed of metal, such as brass or the like, and serves as a heat sink. The casing 1 includes a concave storage part 1a with an opening provided at the upper part of the storage part 1a, a side wall 1b formed so as to surround the storage part 1a, a rectangular concave cavity 1d provided at a bottom portion 1c of the storage part 1a, and a pair of screw holes 1e formed with the cavity 1d provided therebetween.

A circuit board 2, which is formed of a printed circuit board, includes a pair of holes 2a and 2b formed with a predetermined distance therebetween, a rectangular through hole 2c which is provided between the holes 2a and 2b and is shorter than the cavity 1d of the casing 1, a pair of mounting holes 2d provided so as to be opposed to each other with the through hole 2c provided therebetween, and a plurality of small holes 2e provided around the through hole 2c.

On a top surface of the circuit board 2, wiring patterns 3a and 3b formed of conductive patterns and a grounding pattern 4 formed of a conductive pattern are provided. The through hole 2c separates the top surface of the circuit board 2 into first and second regions R1 and R2.

Portions of the wiring patterns 3a and 3b formed in the first and second regions R1 and R2 are opposed to each other, with the through hole 2c provided therebetween, and extend to the middle of the through hole 2c, thereby forming probes 5a and 5b. The grounding pattern 4 is formed around the peripheries of the through hole 2c and the mounting holes 2d while keeping away from the probes 5a and 5b. The grounding pattern 4 is connected to a ground pattern (not shown) formed on the whole back surface of the circuit board 2 by a connecting conductor (not shown) provided in the small holes 2e.

The above-described circuit board 2 is stored in the storage part 1a while the ground pattern is disposed on the bottom portion 1c of the storage part 1a. At this point, the through hole 2c engages the cavity 1d provided on the bottom portion 1c, and the probes 5a and 5b, which are above the cavity 1d, are located at positions near both ends of the cavity 1d.

Amplifying elements (FETs) 6a and 6b, which are bare chips, are inserted into the holes 2a and 2b of the circuit board 2. The amplifying elements 6a and 6b are fixed at the bottom thereof to the bottom portion 1c of the casing 1 using electrically conductive adhesive.

Wires 7 are bonded to the amplifying elements 6a and 6b, and hence the amplifying elements 6a and 6b are connected to the wiring patterns 3a and 3b formed in the first and second regions R1 and R2, respectively.

Various electrical components (not shown) are connected to the wiring patterns 3a and 3b formed in the first and second regions R1 and R2, respectively, using solder. With these electrical components and the bare-chip amplifying elements 6a and 6b, a first amplifier circuit 8a including a bias circuit or the like is formed in the first region R1, and a second amplifier circuit 8b including a bias circuit or the like is formed in the second region R2.

A rectangular main body 9 formed of metal includes a concave cavity 9a with an opening provided on the underside of the cavity 9a, a side wall 9b provided so as to surround the cavity 9a, a plurality of concave portions 9c which are provided at the edge of the side wall 9b and are formed so as to be joined to the concavity 9a from the outside, and a pair of mounting holes 9d which hold the cavity 9a therebetween and which penetrate vertically.

The opening of the main body 9 is opposed to the bottom portion 1c of the casing 1. The cavity 9a is opposed to the cavity 1d of the casing 1. Accordingly, the main body 9 is mounted on the grounding pattern 4 on the circuit board 2.

The main body 9 is grounded by the grounding pattern 4, and the circuit board 2 is held between the main body 9 and the bottom portion 1c.

At the same time, the probes 5a and 5b are located at the concave portions 9c of the main body 9, and continuity to the main body 9 is prevented. The probes 5a and 5b, the main body 9, and the bottom portion 1c form a waveguide filter 10.

The main body 9 of the waveguide filter 10 is arranged parallel to the side wall 1b defining the storage part 1a. The main body 9 separates the storage part 1a into first and second chambers 11a and 11b.

In the first chamber 11a, the first amplifier circuit 6a is arranged. In the second chamber 11b, the second amplifier circuit 6b is arranged. The main body 9, which is the waveguide filter 10, provides electrical shielding between the first and second amplifier circuits 6a and 6b.

A covering plate 12 formed of metal includes a pair of mounting holes 12a. The covering plate 12 is laid over on the casing 1 so as to cover the opening of the casing 1. A pair of screws 13 penetrate through the mounting holes 12a of the covering plate 12, the mounting holes 9d of the main body 9, and the mounting holes 2d of the circuit board 2, and the screws 13 are screwed into the screw holes 1e of the casing 1. The covering plate 12, the main body 9, and the circuit board 2 are mounted on the casing 1 using the screws 13.

By screwing in the screws 13, the inside of the covering plate 12 is brought into contact with the top surface of the main body 9, which is the waveguide filter 10. Electrical shielding between the first and second chambers 11a and 11b is further improved. By pressing the main body 9 downward using the covering plate 12, the circuit board 2 is securely held between the main body 9 and the bottom portion 9. Hence, the circuit board 2 is reliably maintained, and contact between the main body 9 and the grounding pattern 4 is ensured.

With the above arrangement, the radio frequency amplifier according to the embodiment of the present invention is formed.

Although the waveguide filter 10 has the foregoing structure, it can be formed using various structures other than the foregoing structure.

## Claims

1. A radio frequency amplifier comprising:
a casing (1) formed of metal, said casing including a storage part (1a);
a circuit board (2) provided in said storage part, on which first and second amplifier circuits (8a, 8b) are formed; and
a filter provided between the first and second amplifier circuits;
wherein said filter includes a waveguide filter being disposed in said storage part and comprising a main body (9) formed of metal that encloses a cavity (9a), wherein the cavity (9a) of the main body is provided with an opening on the underside thereof and is opposed to a bottom portion (1c) of said casing, and wherein the bottom portion is provided with a cavity (1d) arranged to oppose the cavity (9a) of the main body; wherein said main body separates said storage part into first and second chambers (R1, R2), the first amplifier circuit being formed in the first chamber, and the second amplifier circuit being formed in the second chamber; the waveguide filter being mounted between the first and second amplifier circuits to provide electrical shielding between the first and second amplifier circuits.

2. A radio frequency amplifier according to claim 1, wherein the first and second amplifier circuits comprise first and second amplifying elements (6a, 6b) respectively, the amplifying elements being bare chips; and
the first and second amplifying elements are connected to a wiring pattern (3a, 3b) in said circuit board, with the waveguide filter provided between the amplifying elements.

3. A radio frequency amplifier according to claims 1 or 2, wherein the bottom portion and the main body form the waveguide filter.

4. A radio frequency amplifier according to claim 1, 2 or 3, wherein said circuit board is provided between the bottom portion and the main body, and a probe (5a, 5b) is formed by part of the wiring pattern on said circuit board.

5. A radio frequency amplifier according to any preceding claim further comprising a covering (12) for covering the opening of said storage part, wherein the inside of the covering is brought into contact with a top surface of the waveguide filter.

## Patentansprüche

1. Hochfrequenzverstärker, der Folgendes aufweist:
ein Gehäuse (1), das aus Metall gebildet ist, wobei das Gehäuse einen Unterbringungsbereich (1a) aufweist;
eine Schaltungsplatte (2), die in dem Unterbringungsbereich vorgesehen ist und auf der eine erste und eine zweite Verstärkerschaltung (8a, 8b) ausgebildet sind; und
ein Filter, das zwischen der ersten und der zweiten Verstärkerschaltung vorgesehen ist;
wobei das Filter ein Wellenleiter-Filter aufweist, das in dem Unterbringungsbereich angeordnet ist und einen aus Metall gebildeten Hauptkörper (9) aufweist, der einen Hohlraum (9a) umschließt,
wobei der Hohlraum (9a) des Hauptkörpers an seiner Unterseite mit einer Öffnung versehen ist und einem Bodenbereich (1c) des Gehäuses gegenüberliegt und wobei der Bodenbereich mit einem Hohlraum (1d) versehen ist, der dem Hohlraum (9a) des Hauptkörpers gegenüberliegend angeordnet ist;
wobei der Hauptkörper den Unterbringungsbereich in eine erste und eine zweite Kammer (R1, R2) trennt, wobei die erste Verstärkerschaltung in der ersten Kammer ausgebildet ist und die zweite Verstärkerschaltung in der zweiten Kammer ausgebildet ist;
wobei das Wellenleiter―Filter zwischen der ersten und der zweiten Verstärkerschaltung angebracht ist, um eine elektrische Abschirmung zwischen der ersten und der zweiten Verstärkerschaltung zu schaffen.

2. Hochfrequenzverstärker nach Anspruch 1,
wobei die erste und die zweite Verstärkerschaltung ein erstes bzw. ein zweites Verstärkungselement (6a, 6b) aufweisen, wobei es sich bei den Verstärkungselementen um blanke Chips handelt; und
wobei das erste und das zweite Verstärkungselement mit einem Leitermuster (3a, 3b) auf der Schaltungsplatte verbunden sind, wobei das Wellenleiter - Filter zwischen den Verstärkungselementen vorgesehen ist.

3. Hochfrequenzverstärker nach Anspruch 1 oder 2,
wobei der Bodenbereich und der Hauptkörper das Wellenleiter-Filter bilden.

4. Hochfrequenzverstärker nach Anspruch 1, 2 oder 3,
wobei die Schaltungsplatte zwischen dem Bodenbereich und dem Hauptkörper vorgesehen ist und eine Sonde (5a, 5b) durch einen Teil des Leitermusters auf der Schaltungsplatte gebildet ist.

5. Hochfrequenzverstärker nach einem der vorausgehenden Ansprüche, weiterhin mit einer Abdeckung (12) zum Abdecken der Öffnung des Unterbringungsbereichs, wobei das Innere der Abdeckung mit einer oberen Oberfläche des Wellenleiter-Filters in Berührung gebracht ist.

## Revendications

1. Amplificateur à haute fréquence comprenant :
un boîtier (1) formé de métal, ledit boîtier comprenant une partie de logement (1a),
une carte imprimée (2) prévue dans ladite partie de logement, sur laquelle des premier et second circuits d'amplificateurs (8a, 8b) sont formés, et
un filtre prévu entre les premier et second circuits d'amplificateurs,
dans lequel ledit filtre comprend un filtre en guide d'ondes placé dans ladite partie de logement et comprenant un corps principal (9) formé de métal qui entoure une cavité (9a), où la cavité (9a) du corps principal est munie d'une ouverture sur le côté inférieur de celle-ci et est opposée à une partie inférieure (1c) dudit boîtier, et où la partie inférieure est munie d'une cavité (1d) agencée pour être opposée à la cavité (9a) du corps principal, et où ledit corps principal sépare ladite partie de logement en des première et seconde chambres (R1, R2), le premier circuit d'amplificateur étant formé dans la première chambre et le second circuit d'amplificateur étant formé dans la seconde chambre, le filtre en guide d'ondes étant monté entre les premier et second circuits d'amplificateurs pour procurer un blindage électrique entre les premier et second circuits d'amplificateurs.

2. Amplificateur à haute fréquence selon la revendication 1, dans lequel les premier et second circuits d'amplificateurs comprennent respectivement des premier et second éléments d'amplification (6a, 6b), lesdits éléments d'amplification étant des puces nues ; et
les premier et second éléments d'amplification sont reliés à un motif de câblage (3a, 3b) sur ladite carte imprimée, et le filtre en guide d'ondes étant disposé entre les éléments d'amplification.

3. Amplificateur à haute fréquence selon la revendication 1 ou 2, dans lequel la partie inférieure et le corps principal forment le filtre en guide d'ondes.

4. Amplificateur à haute fréquence selon la revendication 1, 2 ou 3, dans lequel ladite carte imprimée est agencée entre la partie inférieure et le corps principal, et une sonde (5a, 5b) est formée par une partie du motif de câblage sur ladite carte imprimée.

5. Amplificateur à haute fréquence selon l'une quelconque des revendications précédentes, comprenant en outre un couvercle (12) destiné à couvrir l'ouverture de ladite partie de logement, où le côté intérieur du couvercle est amené en contact avec une surface supérieure du filtre en guide d'ondes.
